# EUROPEAN PATENT SPECIFICATION

(11) **EP 1 977 029 B1**
(45) Date of publication and mention of the grant of the patent: **22.07.2020**
(21) Application number: 06845438.8
(22) Date of filing: 15.12.2006
(51) Int. Cl.: C30B 29/40, C30B 25/00, C01B 21/06, C01B 21/072

(54) **CRYSTALLINE COMPOSITION**
KRISTALLINE ZUSAMMENSETZUNG
COMPOSITION CRISTALLINE

(30) Priority: 20.12.2005 US 313442; 20.12.2005 US 313528; 20.12.2005 US 313451
(43) Date of publication of application: 08.10.2008
(73) Proprietor: SLT Technologies, Inc., Los Angeles, CA 90067 (US)
(72) Inventor: LEMAN, John, Thomas, Niskayuna, NY 12309 (US); PARK, Dong-sil, Niskayuna, NY 12309 (US); D'EVELYN, Mark, Philip, Niskayuna, NY 12309 (US); PETERSON, Miles, Standish, Delason, New York 12053 (US); SHARIFI, Fred, Niskayuna, NY 12309 (US); HIBSHMAN, Joell, Randolph, Delanson, NY 12053 (US)
(74) Representative: Biggi, Cristina
(86) International application number: PCT/US2006/047743
(87) International publication number: WO 2007/078844

(56) References cited:
- WO-A-98/19964
- WO-A-2004/003261
- US-A1- 2003 226 497
- US-A1- 2005 142 391

## Description

### FIELD OF THE INVENTION

The invention relates to a crystalline composition.

### BACKGROUND OF THE INVENTION

In some preparations of crystalline compositions, such as polycrystalline group III metal nitrides, relatively fine powder particles or films of modest thickness are produced. The powder form may have little or no appreciable mechanical or electrical bonding between the grains, and may not be strongly bonded, dense or cohesive. For use as a sputter target, the bulk polycrystalline material should be strongly bonded, dense, and cohesive. Items made from the powder form have an undesirable high residual porosity and/or moisture sensitivity, which easily disintegrate and dissolve. For a crystalline growth source, an article should not easily disintegrate back into solution.

Several chemical vapor deposition processes are used to form a polycrystalline metal nitride film in the prior art. Some suffer from a difficulty in scaling up and/or precision control of the gas phase reaction processes leading to poor quality control. Such difficulty is due to a use of initially solid materials as reactants, or may be due to extreme reaction conditions. Sometimes, the films contain undesirable levels of contaminants, which may make those films relatively less suitable for use in, for example, ammonothermal crystalline growth. The invention relates to crystals having improved properties than those crystals currently available, wherein the crystals are made by a method employing a group III metal as a starting material. In one embodiment, the crystals are made using a reactor apparatus wherein at least one raw material inlet is configured to flow molten liquid group III metal raw material there through.

WO98/19964 describes a polycrystalline GaN having a dendritic morphology or a thin platelet shape. Dendritic morphology and platelet shape do not correspond to a columnar structure.

### SUMMARY OF THE INVENTION

In one embodiment of the invention, a composition including a polycrystalline gallium nitride having plurality of grains is provided. The grains have a columnar structure having an average grain size that is in a range of from 10 nm to 1 millimeter. In another embodiment, the metal nitride is characterized by an impurity content < 200 ppm, a porosity in volume fraction ranging from 0.1 - 30%, an apparent density ranging from 70 - 99.8 %, an atomic fraction of the metal that is in a range of from 0.49 to 0.55.

In one embodiment, an article is provided that is formed from the polycrystalline gallium nitride composition. In another embodiment, a device is provided that includes an article comprising the polycrystalline gallium nitride.

A method for making polycrystalline metal nitride is disclosed. The process comprises the steps of flowing a nitrogen-containing gas and a halide-containing gas into a chamber defined by a housing, wherein the gases are mixed to form a gas mixture, which contacts a group III metal in the chamber, forming a metal nitride. The chamber contains at least one of a riffled surface, a baffle, an aperture, and a frit to promote mixing of the nitrogen-containing gas and the halide-containing gas.

An apparatus for making the polycrystalline metal nitride is disclosed, wherein the apparatus includes inlets in communication with the chamber such as, a first inlet, a second inlet, and a raw material inlet configured to flow a molten liquid group III metal raw material there through, a nitrogen-containing gas, a halide-containing gas and raw material, into the chamber, respectively. The apparatus further may include a sensor that is operable to sense one or more of temperature or pressure in the chamber.

### DESCRIPTION OF THE DRAWINGS

Fig. 1 is a schematic side view of an apparatus of the disclosure;
Fig. 2 is a schematic side view of an apparatus of the disclosure;
Fig. 3 is a schematic side view of an apparatus of the disclosure;
Fig. 4 is a schematic side view of an apparatus of the disclosure;
Fig. 5 is a schema tic side view of an apparatus of the disclosure;
Fig. 6 is a flow chart of a method for making a crystalline composition;
Fig. 7 is an SEM image showing a cross-section of polycrystalline gallium nitride;
Fig. 8 is an SEM image showing a growth surface of polycrystalline gallium nitride; and
Fig. 9 is a graph of the bend strength of gallium nitride.

### DETAILED DESCRIPTION OF THE INVENTION

Approximating language, as used herein throughout the specification may be applied to modify any quantitative representation that could permissibly vary without resulting in a change in the basic function to which it may be related. Accordingly, a value modified by a term such as "about" may be not to be limited to the precise value specified. In at least one instance, the variance indicated by the term about may be determined with reference to the precision of the measuring instrumentation.

As used herein, the term "free" may be combined with a term; and, may include an insubstantial number, or a trace amount, while still being considered free of the modified term unless explicitly stated otherwise.

According to one embodiment of the invention, a composition of a polycrystalline gallium nitride is provided. The polycrystalline gallium nitride has a plurality of grains, and these grains have a columnar structure. The grains may be characterized by one or more properties including but not limited to a grain dimension, an average number of grains/ unit volume, inter-grain bend strength or a tilt angle of the grains relative to each other.

The grain dimension may refer to either an average grain size or an average grain diameter. The grains have a columnar structure, i.e., a major axis. The average grain size refers to an average length of the grains along the major axis. Perpendicular to the major axis may be one or more minor axes, and the average diameter of each grain may be determined with reference to the minor axes. Collectively, the average diameters of each of the grains may be aggregated and averaged to provide the average grain diameter. An average, as used herein, may refer to the mean value. The aspect ratio of the grains means the ratio of the average grain size to the average grain dimeter. In one embodiment, the aspect ratio ranges between about 2 and about 5. In a second embodiment, between about 5 and about 20. In a third embodiment, the aspect ratio is greater than 20.

In one embodiment, the average grain size of the polycrystalline metal nitride is > 10 nm. In one embodiment, the average grain size is in a range of from 0.01 µm to 1 mm, while in certain other embodiments, the grain size is in a range of from 0.01- 30 µm. Another embodiment, from 30 - 50 µm. Yet another embodiment, from 50 - 100 µm. In one embodiment, from 100 - 500 µm, from 500 µm to 1 mm, or greater than 1 mm. In one embodiment, the average grain diameter is larger than 10 µm. In one embodiment, the average grain diameter is in a range of from 10 - 20 µm. In another embodiment, from 20 - 30 µm. A third embodiment, from 30 - 50 µm. A fourth embodiment, from 50 - 100 µm. In yet another embodiment, in ranges from 100 - 500 µm, from 500 - 1 mm, or greater than 1 mm.

An average number of grains/ unit volume of the crystalline composition may indicate a grain average or granularity. The composition may have an average number of grains/ unit volume of greater than 100 per cm³. In one embodiment, the average number of grains/ unit volume is in a range of from 100 - 1000 per cm³, from 1000 - 10,000 per cm³, from 10,000 - 10⁵ per cm³, or greater than 10⁵ per cm³.

The grains may be oriented at a determined angle relative to each other. The orientation may be referred to as the tilt angle, which may be greater than 1 degree. In one embodiment, the grain orientation or tilt angle is in a range of from 1 - 3 degrees, from 3 - 5 degrees, from 5 - 10 degrees, from 10 - 15 degrees, from 15 - 30 degrees, or greater than 30 degrees.

Properties that are inherent in or particular to one or more crystalline articles produced according to an embodiment of the invention include bend strength, density, moisture resistance, and porosity, among others. The properties can be measured using standard test including but not limited to ASTM C1499.

The inter-grain bend strength of a thin film of one or more of the crystals in one embodiment is greater than 20 Mega Pascal (MPa). In one embodiment, the inter-grain bend strength is in a range of from 20 - 50 MPa. Another embodiment, from 50 - 60 MPa, from 60 - 70 MPa, from 70 - 75 MPa, from 75 - 80 MPa, from 80 - 90 MPa, or > 90 MPa. The bend strength may indicate the grain-to-grain relationship at the inter-grain interface and/or the inter-grain strength.

The apparent density of crystalline articles in one embodiment is > 1 g/ cubic centimeter (g/cc or g/cm³). In one embodiment, the density is in a range of from 1 - 1.5 g/cm³, from 1.5 - 2 g/cm³, from 2 - 2.5 g/cm³, from 2.5 - 3 g/cm³, or > 3 g/cm³. The crystalline composition density can be a function of, for example, the porosity or lack thereof, the crystal packing arrangement, and the like.

The crystalline article is gallium nitride ("GaN") with an apparent density of less than 6.1 g/ cm³ at standard test conditions. In one embodiment, the GaN crystalline article has an apparent density in a range of from 6.1 - 5.49 g/ cm³. Another embodiment, from 5.49 - 4.88 g/cm³. Yet a third embodiment, from 4.88 - 4.27 g/cm³, from 4.27- 4 g/cm³, or < 4 g/cm³.

The moisture resistance of the polycrystalline composition in one embodiment is greater than 0.001 g/hr. at 100 % humidity at room temperature. In yet another embodiment, the moisture resistance is in a range of from 0.001 - 0.01 g/hr., from 0.01 - 0.1 g/hr., or in another embodiment of < 0.1 g/hr. The moisture resistance of the composition indicates its resistance to intake of moisture, the hygroscopic proclivity of the composition, the surface treatment, the surface area/ weight, the porosity, and/or the ease with which the composition may dissociate in a solution. The inter-grain bend strength can also contribute to the ease with which the composition may dissociate in a solution.

In one embodiment, the porosity of the polycrystalline composition is less than 30 vol.%. In one embodiment, the porosity is from 30 - 10 vol. %. In a second embodiment, from 10 - 5 vol. %. In a third embodiment, from 5 - 1 vol. %. A fourth embodiment, from 1 - 0.1 vol. %. In yet another embodiment, < 0.1 vol. %.

The metal of the metal nitride is gallium.

In one embodiment, the atomic fraction of the metal, in the metal nitride is selected such that there is little or no excess metal in the metal nitride. In one embodiment, the atomic fraction of the metal is greater than 49 %. In another embodiment, the atomic fraction is in a range of from 49 - 50 %. A second embodiment, from 50 - 51 %, from 51 % - 53 %, from 53 - 55 %, or > 55 %.

In one embodiment, the metal nitride composition contains an impurity. Impurities may be unintended and/or undesirable inclusions in the final product, e.g., resulting from, for example, processing and handling. Other impurities may result from contaminants in raw material. Some impurities are associated with raw materials. Impurities are distinguished from dopants in that the impurity does not intentionally aid in the function of the product, or produces an undesirable effect in the final product. Undesirable effects may include color, optical absorption, electrical properties (such as carrier mobility, resistance, or conductivity), or the like. Dopants are disclosed herein below. In one embodiment, the impurity includes residual oxygen resulting from the metal raw material. In one embodiment, the oxygen content is less than 100 ppm. In another embodiment, the oxygen content is in a range of from 100 70 ppm, or from 70 - 40 ppm. Another embodiment, from 40 - 20 ppm, or < 20 ppm. Parts per million or ppm refers to "by weight" unless otherwise indicated.

The impurity content refers to any one of the impurities and not to the total impurity amount. In one embodiment, the impurity content in the polycrystalline composition is less than 200 ppm. In another embodiment, the impurity content is in a range of from 200 - 100 ppm, from 100 - 50 ppm, from 50 - 40 ppm, from 40 - 30 ppm, from 30 - 20 ppm, from 10 - 5 ppm, or < 5 ppm.

With regard to dopants and dopant precursors (collectively "dopants" unless otherwise indicated), the electric, magnetic, and luminescent properties of the metal nitride composition are controlled by adding one or more of such dopants to the above composition during processing. In one embodiment, suitable dopants include one or more of s or p block elements. Suitable s and p block elements include, for example, one or more of silicon, germanium, magnesium, or tin. Other suitable dopants include one or more of transition group elements. Suitable transition group elements include but are not limited to one or more of, for example, zinc, scandium, zirconium, titanium, iron, vanadium, manganese, chromium, cobalt, copper, nickel, or hafnium. Examples of dopants include one or more of lanthanides, e.g., praseodymium, europium, thulium, or erbium.

In one embodiment, suitable dopants produce an n-type material, or a p-type material. In another embodiment, the dopants produce one or more of semi-insulating material, magnetic material, or luminescent material. In one embodiment, rather than constituting an impurity, oxygen is intentionally added as a dopant.

In one embodiment, the dopant concentration level in the polycrystalline composition is greater than 10¹⁰ atoms/cm³. In one embodiment, the dopant concentration is in any of ranges of 10¹⁰ - 10¹⁵ atoms/cm³, 10¹⁵ - 10¹⁶ atoms/cm³, 10¹⁶ - 10¹⁷ atoms/cm³, 10¹⁷ - 10¹⁸ atoms/cm³, 10¹⁸ - 10²¹ atoms/ cm³, or > 10²¹ atoms/cm³.

In one embodiment, the composition is formed as an article, e.g., as an intermediate article. Examples include a boule or an ingot, and are further processed. Post-formation processing of the boule or the ingot yields, for example, a wafer. The wafer can be further worked upon, e.g., being etched, polished, cut or diced, for use as a sputtering target, a transducer, or a device.

The shape of the processed article is determined with reference to one or more requirements of the end usage, e.g. a shape with one or more dimensions of length, height, or width > 0.5 mm. In another embodiment, dimensions of length, height, or width in a range of from 0.5 - 1 mm, or > 1 mm. In one embodiment, a thickness > 5 mm. In another embodiment, the article has a shape with two or more dimensions of length, height, or width in a range of from 0.5 - 1 mm, from 1 - 5 mm, from 5 - 10 mm, or > 10 mm.

The surface of the article in one embodiment is relatively smooth. The article may have one or more surfaces that have a root mean square roughness of less than 100 nanometer (nm). In one embodiment, the root mean square roughness is in a range of from 100 - 50 nm, from 50 - 10 nm, from 10 - 5 nm, from 5 - 3 nm, from 3 - 2 nm, from 2 - 1 nm, or < 1 nm. The measurement techniques may include one or more of an atomic force microscope, mechanical and optical profiler, co focal laser scanning microscope, angle-resolved scattering, and total scattering.

In one embodiment, the article includes one or more additional layers that differ from each adjacent layer. The layers in one embodiment include one or more of a metal, an insulator, or a semiconductor. In a non-limiting example, a GaN substrate is provided, and an AIGaN layer is epitaxially grown onto a surface of the substrate. Further, an n-doped GaN layer is disposed over the AIGaN layer. Additional and/or alternate layers can be added after processing steps, such as etching and/or polishing. In one example, conductive contacts are added to form, for example, a diode.

In one embodiment, the article is incorporated into one or more transducer devices. Optionally, one or more structure is secured to the article. Suitable structures are selected from a group consisting of a cathode, an anode, an electrically conducting lead, or a combination of two or more thereof. Other suitable devices include a piezoelectric transducer, an optoelectronic device or an electronic device. Particular examples of suitable devices may include one or more of a photovoltaic diode, or a light emitting diode (LED), or a sensor, or a detector.

An apparatus is described which includes sub-systems, such as a housing, one or more supply sources, and a control system. The housing includes one or more walls, components, and the like. The wall of the housing can be made of a metal, a refractory material, or fused silica. In one embodiment, the housing has an inner wall, and an outer wall spaced from the inner wall, wherein an inner surface of the inner wall defines a chamber.

The wall of the housing is configured (e.g., shaped or sized) with reference to processing conditions and the desired end use. The configuration may depend on the size and number of components and the relative positioning of those components, in the chamber. In one embodiment, the housing is cylindrical with an outer diameter in a range of from 5 cm - 1 m, and a length of from 20 cm - 10 m. The housing can be elongated horizontally, or vertically. The orientation of the elongation may affect one or more processing parameters. For example and as discussed in further detail herein below, for a horizontal arrangement, a series of crucibles are arranged in a series such that a stream of reactants flow over the crucibles one after another. In one embodiment of such an arrangement, the concentration and composition of the reactant stream differ at the first crucible in the series relative to the last crucible in the series.

Depending on the process conditions, other configuration changes can be made such as rearrangement of the crucibles, redirection of the reactant stream, multiple reactant stream inlets, and the like.

In one embodiment, a liner is disposed on the inner surface of the inner wall along the periphery of the chamber. Suitable liner material may include graphite or other materials, e.g., metals, as long as the material is not a source of undesirable contaminants. The liner functions to prevent or reduce material deposition on the inner surface of the inner wall. In one embodiment, the liner is removable so as to allow the deposited material to be stripped from the inner wall during a cleaning process or replacement of the liner.

In one embodiment with an inner wall that is concentric to and spaced from the outer wall, the space in-between defines a pathway between the inner wall and the outer wall for environmental control fluid to flow there-through. Examples of environmental control fluid include gas, liquid or supercritical fluid. Suitable environmental control fluids used for circulation include inert gases. In one embodiment, a control inlet extends through the outer wall to the space. A valve blocks the control fluid from flowing through the inlet and into the pathway to circulate between the inner and outer walls. In one embodiment, the inlet is part of a circulation system, which may heat and/or cool the environmental control fluid and may provide a motive force for the fluid. The circulation system may communicate with, and respond to, the control system. Flanges, such as those meant for use in vacuum systems, can be used to provide a leak-proof connection for the inlet.

Components of the housing can include, for example, one or more inlets (such as raw material inlets and dopant inlets), outlets, filters, heating elements, cold walls, pressure responsive structures, crucibles, and sensors. In one embodiment, some components couple to one or more of the walls, and some extend through the walls to communicate with the chamber, even while the housing is otherwise sealed. The inlet and the outlet may further include valves.

In one embodiment, the inlet and the outlet lines are made from materials suitable for semiconductor manufacturing, e.g., stainless steel. The inlet and/or outlet is welded to the respective wall, or is secured to the wall by one or more metal-to-metal seals. Optionally, the inlets and/or outlets may include purifiers. In one embodiment, the purifier includes a getter material, for example a zirconium alloy which may react with the contaminants to form the respective nitrides, oxides and carbides, thus reducing the probability of contamination in the final product. In one embodiment, the purifiers are placed in or just upstream of the inlets at the entrance to the chamber. For reactions utilizing large quantities of ammonia the main concern for contamination is the presence of water due to hygroscopic nature of ammonia. The contamination of ammonia drawn from an ammonia tank may increase exponentially as the ammonia tank empties and when 70% of ammonia is reached, the tank is replaced. Alternatively, a point-of-use purifier is utilized at the inlets. The use of a point-of-use purifier helps in controlling the contamination in ammonia thereby reducing ammonia wastage. Optionally, lower grade ammonia is utilized along with the point-of-use purifier to obtain the required grade of about 99.9999 %.

The shape or structure of the inlets and outlet is modified to affect and control the flow of fluid there-through. For example, an inner surface of the inlet/outlet may be rifled. The rifling may spin the gas flowing out through the ends and enhance mixing. In one embodiment, the inlets are coupled together such that the reactants pre-mix before they reach reaction zone or hot zone. Each of the inlets and outlets has an inner surface that defines an aperture through which material can flow into, or out of, the chamber. Valve apertures are adjustable from fully open to fully closed thereby allowing control of the fluid flow through the inlets and the outlets.

The inlet lines are configured to promote mixing of the nitrogen-containing gas and the halide-containing gas upstream of the crucible(s), so as to promote uniform process conditions throughout the volume of the chamber. In one embodiment, one or more of the inlets can contain one or more of baffles, apertures, frits, and the like, in order to promote mixing. The apertures, frits, and baffles are placed within the chamber proximate to the hot zone or crucibles so as to control the flow of gas in the chamber, which may prevent or minimize the formation of solid ammonium halide.

In one embodiment, the apertures, frits, and baffles are placed upstream of the nearest crucible, with a distance of separation that is in a range from 2 cm to 100 cm, in order for mixing to be complete prior to the onset of reaction with the contents of the crucible. The presence of apertures and baffles promotes higher gas velocities that promote mixing and inhibit back-flow of gases, preventing or minimizing the formation of solid ammonium halide.

One or more crucibles are placed within the chamber. In one embodiment, the number of crucibles within the chamber is 6. Depending on the configuration of the chamber, the crucibles are arranged horizontally and/or vertically within the chamber. The crucible shape: and size is pre-determined based on the end usage of the metal nitride, the raw material types, and the processing conditions. For the polycrystalline composition to be useful as a sputter target, the size of the crucible is relatively larger than the required size of the sputter target. The excess of the polycrystalline composition is removed, for example, through etching or cutting, to form the sputter target article. Such removal eliminates surface contamination resulting from contact with the crucible material.

The crucible is selected to withstand temperatures in excess of the temperature required for crystalline composition formation while maintaining structural integrity, and chemical inertness. The temperature can be > 200°C. In one embodiment, it ranges from 200 - 1200°C. In another embodiment, the temperature is > 1200°C. Accordingly, refractory materials are suitable for use in the crucible. In one embodiment, the crucible comprises a refractory composition including an oxide, a nitride, or a boride. In one example, the crucible is formed from one or more of silicon, aluminum, magnesium, boron, zirconium, beryllium, graphite, molybdenum, tungsten, or rhenium or their respective oxides, nitrides or borides. In one embodiment, a removable graphite liner is placed inside the crucible so as to facilitate easy removal of the polycrystalline composition.

Suitable sensors may include one or more of pressure sensors, temperature sensors, and gas composition sensors. The sensors are placed within the chamber and communicate the process parameters in the chamber to the control system.

Suitable supply sources include one or more of an energy source, a nitrogen-containing gas source, a carrier gas source, a halide-containing gas source, a raw material source (sometimes referred to as a reservoir), environmental control fluid source, and the like.

The energy source is located proximate to the housing and may supply energy, such as thermal energy, plasma energy, or ionizing energy to the chamber through the walls. The energy source is present in addition to, or in place of, the heating elements disclosed above. In one embodiment, the energy source may extend along an outward facing surface of the outer wall of the housing. In one embodiment, the energy source is selected from one of a microwave energy source, a thermal energy source, a plasma source, or a laser source. In one embodiment, thermal energy is provided by a heater. Suitable heaters may include one or more molybdenum heaters, split furnace heaters, three zone split furnaces, or induction heaters.

Sensors are placed. within the chamber. The sensors are capable of withstanding high temperature and elevated or reduced pressure in the chamber. In one example, chemically inert sensors are used. The sensors are placed proximate to the crucible, and/or are placed at the inlets. The sensors monitor process conditions such as temperature, pressure, gas composition and concentration within the chamber.

The nitrogen-containing gas source communicates through a first inlet with the chamber. The nitrogen-containing gas source in one embodiment includes one or more filters, purifiers, or driers to purify and/or dry the nitrogen-containing gas. In one embodiment, the nitrogen-containing gas is produced at the source. The purifier maintains purity levels of the nitrogen-containing gas up to or above semiconductor grade standards for purity. Suitable nitrogen-containing gases include ammonia, diatomic nitrogen, and the like. Where the presence of carbon is not problematic, nitrogen-containing organics are used.

Controlling the aperture of the associated valve allows control of the flow rate of the nitrogen-containing gas into the chamber. Unless otherwise specified, flow rate will refer to volumetric flow rate. Processing considerations, sample size, and the like determine an appropriate flow rate of the gas, typically greater than 10 (standard) cubic cm/ minute. In one embodiment, the flow rate of nitrogen-containing gas is in a range of 10 -100 cm³/min. A second embodiment, from 100 - 200 cm³/min. A third embodiment, from 200 -500 cm³/min. In yet another embodiment, from 3000 4000 cm³/min., from 4000 cm³/min. to 5000 cm³/min., or greater than 5000 cm³/min.

The carrier gas source communicates with the chamber through an inlet, or may share the first inlet with the nitrogen-containing gas. Pre-mixing the nitrogen-containing gas with the carrier gas dilutes the nitrogen-containing gas to a determined level. Because the nitrogen-containing gas is diluted with the carrier gas, which is inert, the likelihood of formation of certain halide solids proximate to the first inlet in the chamber is reduced. Suitable carrier gases may include one or more of argon, helium, or other inert gases. In one embodiment, the carrier gas inlet is positioned so that a stream of carrier gas may impinge on a stream of nitrogen-containing gas exiting the first inlet. Dopants are entrained in the carrier gas, in one embodiment, for inclusion in the polycrystalline composition.

The halide-containing gas source communicates through a second inlet with the chamber. As with the nitrogen-containing gas source, the halide-containing gas source may include one or more filters, purifiers, driers, and the like, so that the halide-containing gas be purified and/or dried at the source. The halide-containing gas is produced at the source. Suitable halide-containing gases may include hydrogen chloride and the like.

Controlling the aperture of the associated valve allows control of the flow rate of the halide-containing gas into the chamber. Processing considerations, sample size, and the like, may determine an appropriate flow rate of the gas, typically > 10 (standard) cm³/min. In one embodiment, the flow rate of halide-containing gas is selected from the ranges of 10 - 50 cm³/min., 50 - 100 cm³/min., 100 - 250 cm³/min., 250- 500 cm³/min., 500 - 600 cm³/min., 600 - 750 cm³/min., 750 - 1000 cm³lmin., 1000 -1200 cm³/min., and > 1200 cm³/min.

The halide-containing gas flows into the chamber from the halide-containing gas source through the second inlet. As with the nitrogen-containing gas, the halide-containing gas is pre-mixed with the carrier gas to dilute the halide-containing gas to a determined level. The dilution of the halide-containing gas with an inert carrier gas reduces the likelihood of formation of certain halide solids in the second inlet, proximate to the chamber. Such a formation might reduce or block the flow there-through. Optionally, the carrier gas inlet is positioned such that a stream of carrier gas impinges on a stream of halide-containing gas exiting the second inlet or entering the chamber. In one embodiment, dopants are entrained in the carrier gas for inclusion in the polycrystalline composition.

The halide-containing gas and the nitrogen-containing gas are introduced into the chamber in an order that determines properties of the polycrystalline composition. The manner may include simultaneous introduction at a full flow rate of each component fluid (gas, liquid, or supercritical fluid). Other suitable introduction manners include pulsing one or more of the components, varying the concentration and/or flow rate of one or more components, or staggered introductions, for example, to purge the chamber with carrier gas.

The halide-containing gas and the nitrogen-containing gas inlets are disposed such that the exit end is located in the hot zone in the chamber. In one embodiment, one or more inlet is located in a region of the chamber that, during use, has a temperature of greater than 341 °C at 1 atmosphere. In another embodiment, in a range of from 341 - 370°C. In yet another embodiment, > 370 °C.

The ratio of flow rate of the nitrogen-containing gas to the flow rate of the halide-containing gas is adjusted to optimize the reaction. In one embodiment, the ratio of flow rate of the nitrogen-containing gas to the flow rate of halide-containing gas is in a range of from 30:1 to 15:1. In a second embodiment, from 15:1 to 1:1. In a third embodiment, from 1:1 to 1:10, or from 1:10 to 1:15.

The raw material source may communicate through the raw material inlet and into the crucible, which is in the chamber. As with the other sources, the raw material source can include one or more filters, driers, and/or purifiers. Particularly with reference to the raw material source, purity of the supplied material may have a disproportionately large impact or effect on the properties of the final polycrystalline composition. The raw material is produced just prior to use and is kept in an inert environment to minimize or eliminate contamination associated with atmospheric contact. If, for example, hygroscopic materials are used, or materials that readily form oxides, then the raw material may be processed and/or stored such that the raw material does not contact moisture or oxygen. Further, because the raw material can be melted and flowed into the chamber during processing, in one embodiment, differing materials are used in a continuous process than might be available for use relative to a batch process. Examples of the differences are disclosed herein below.

Suitable raw material is gallium. In one embodiment, the raw material has a purity of 99.9999 % or greater. In another embodiment, the purity is greater than 99.99999 %. The raw material can be a gas; a liquid solution, suspension or slurry; or a molten liquid. The residual oxygen in the metal may further be reduced by heating under a reducing atmosphere, such as one containing hydrogen, or under vacuum.

While all of the materials needed for production are sealed in the chamber during operation in one embodiment; in another embodiment, various materials are added during the process. For example, the raw material may flow through the raw material inlet, out of an exit end, and into a crucible within the chamber. In some embodiments wherein there is a plurality of crucibles, multiple raw material inlets, or one inlet having multiple exit ends, are used to flow raw material into individual crucibles. In one embodiment, the raw material inlet is mounted on a linear motion feed-through structure. Such feed-through structures allow the translation of the exit end of the raw material inlet from crucible to crucible.

The flow and the flow rate of raw material to, and through, the raw material inlet are controlled by a valve. The valve is responsive to control signals from the control system. While the flow rate of the raw material is determined based on application specific parameters, suitable flow rates are larger than 0.1 kg/ hr. In one embodiment, the flow rate is in a range of from 0.1 kg/ hr to 1 kg/ hr. In another embodiment, from 1 kg/ hr to 5 kg/ hr, or greater than 5 kg/ hr.

The dopant inlet is in communication with a reservoir containing dopants and the chamber. The reservoir is made of material compliant to semiconductor grade standards. The reservoir may have provisions to purify dry the dopants. In one embodiment, the reservoir is provided with liners. The liners prevent corrosion of the reservoir material, or reduce the likelihood of contamination of the dopants by the reservoir.

The dopant source is separate, or is co-located with one or more of the other materials being added during processing. H added separately, the dopants flow directly into a crucible by exiting an end of the dopant inlet. As mentioned, the dopant is introduced by pre-mixing with, for example, the raw material, the carrier gas, the halide-containing gas, or the nitrogen-containing gas. Metering of the dopant controls the dopant concentration levels in the polycrystalline composition. Similarly, the placement of the dopant in the polycrystalline composition is obtained by, for example, pulsing, cycling, or timing the addition of the dopant.

In one embodiment, suitable dopants include dopant precursors. For example, silicon may be introduced as SiCl₄. Where carbon is a desired dopant, carbon may be introduced as a hydrocarbon, such as methane, methylene chloride, or carbon tetrachloride. In another embodiment, suitable dopants include a halide or a hydride. In situations where carbon is a desired dopant, or an inconsequential contaminant, metals may be introduced as an organometallic compound. For example, magnesium may be introduced as Mg(C₅H₅)₂, zinc as Zn(CH₃)₂, and iron as Fe(C₅H₅)₂. The flow rate of dopant precursors may be greater than 10 (standard) cm³/min. In one embodiment, the flow rate of the dopant precursors is in a range of from 10 - 100 cm³/min. or from 100 - 500 cm³/min. In another embodiment, from 500 - 750 cm³/min., from 750 - 1200 cm³/min., or > 1200 cm³/min. Alternatively in one embodiment, the dopant is added in elemental form, for example, as an alloy with the raw material. Other suitable dopants may include one or more of Si, O, Ge, Mg, Zn, Sc, Ti, V, Cr, Mn, Fe, Co, Ni, Cu, Zr, Sn, Hf, Pr, Eu, Er, or Tm.

The outlet, and corresponding valve, control the release of material that is inside of chamber. In one embodiment, the released material is vented to atmosphere, or captured to recycle the material. The released material may be monitored for composition and/or temperature by sensors mounted to the outlet. Because contamination may be reduced by controlling the flow of material through the chamber in one direction, the polycrystalline composition may be removed from the chamber by an exit structure in the wall at the outlet side.

In one embodiment, the outlet is coupled to an evacuation system. The evacuation system is capable of forming a reduced pressure in the chamber relative to atmospheric pressure. Suitable chamber pressure may be lower than about 10⁻⁷ millibar. In one embodiment, the chamber pressure is in a range of from 10⁻⁷ millibar to 10⁻⁵ millibar, or greater than 10⁻⁵ millibar. In one embodiment, the chamber pressure is in a range of from 760 Torr to about 50 Torr, from about 50 Torr to 1 Torr, from 1 Torr to 10³ Torr, from 10⁻³ Torr to 10⁻⁵ Torr, or less than 10⁻⁵ Torr. The evacuation may be used for precleaning or during processing.

To make polycrystalline GaN with HCI and ammonia, which at low temperature will condense to form NH₄Cl, two basic strategies can be used for handling the ammonium halide. In one embodiment, the outlet is kept warm so it does not condense and can be trapped downstream. In a second embodiment, a cold trap is employed at the downstream end of the reactor to trap as much of the ammonium halide possible there.

In one embodiment, the control system includes a controller, a processor in communication with the controller, and a wired or wireless communication system that allows the controller to communicate with sensors, valves, sources, monitoring and evaluating equipments, and the like. The controller is programmed to implement a method of growing polycrystalline compositions according to embodiments of the invention.

The resultant polycrystalline composition is a metal nitride. In some embodiments, the metal nitride is doped to obtain one or more of an n-doped or a p-doped composition. In one embodiment, the metal nitride is one of a metallic, semiconducting, semi-insulating or insulating material. Further, each of these compositions may be a magnetic or a luminescent material.

The working of the apparatus and the function of the various components are described below with reference to illustrated embodiments and the drawings.

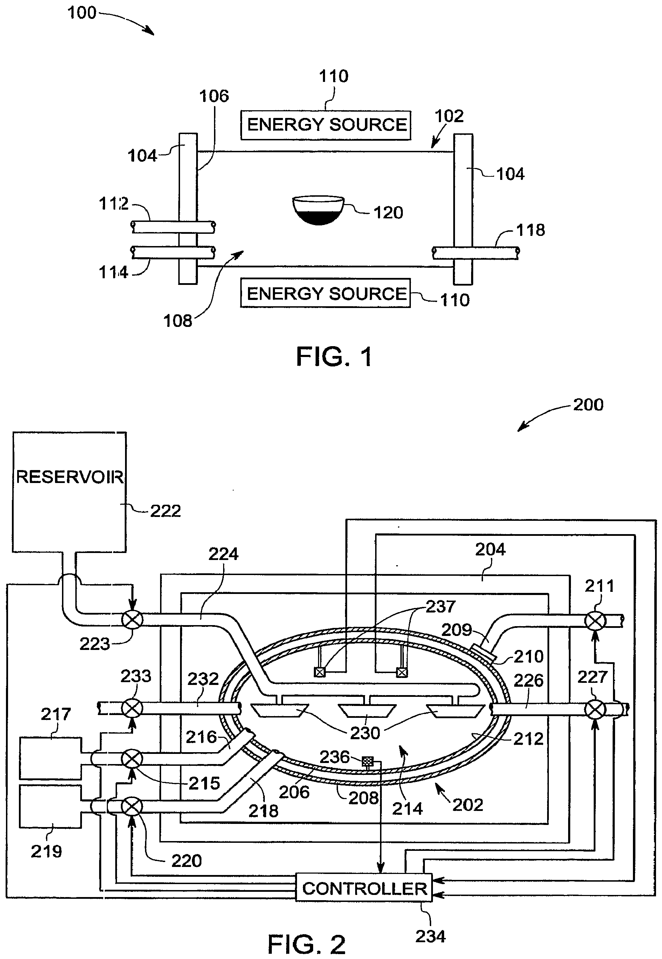

Fig. 1 illustrates an apparatus 100 in accordance with an embodiment. The apparatus 100 includes a housing 102 having a wall 104. The wall 104 has an inner surface 106 defining a chamber 108. An energy source 110 is located proximate to the wall 104. A first inlet 112 and a second inlet 114 extend through the wall 104. The inlets 112, 114 define an aperture through which material can flow into, or out of, the chamber 108. An outlet 118 extends through the wall 104 to the chamber 108. A crucible 120 is disposed in the chamber 108. A liner (not shown) can be used to line the inner surface 106 of the wall 104.

The energy source 110 is a thermal energy source, such as a ceramic heater. The inlets 112, 114 and the outlet 118 comprise stainless steel suitable for semiconductor grade manufacturing. In one embodiment, the crucible 120 comprises boron nitride, and the inert liner comprises graphite.

During operation, a raw material is filled into the crucible 120, and the crucible is preloaded into the chamber. One or more dopants are placed in the crucible with the raw material. After loading, the crucible 120 may be sealed by a sealing mechanism (not shown).

A nitrogen-containing gas flows through the first inlet 112 into the chamber 108. The nitrogen-containing gas includes ammonia and includes a carrier gas for pre-dilution. A halide-containing gas flows through the second inlet 114 and into the chamber 108.

An example of a halide-containing gas is hydrogen chloride. The halide-containing gas is pre-diluted with a carrier gas. Un-reacted gases and/or other waste materials are removed from the chamber 108 through the outlet 118. The chamber 108 is purged by flowing in gases through the inlets 112, 114 and out through the outlet 118 prior to crystalline composition formation. The outflow, optionally, is monitored to detect the impurity level of the out-flowing gas, which may indicate when a sufficient purge has been achieved. The energy source 110 is activated. Activating the energy source 110 increases the temperature within the chamber 108 to pre-determined level and at a pre-determined rate of temperature increase. An area, within the chamber 108 and proximate to the crucible 120 defines a hot zone or reaction zone (not shown).

The raw material, already in the crucible 120, responds to contact with the nitrogen-containing gas in the presence of the halide-containing gas, and at the determined temperature, by reacting to form a nitride of the metal, that is, the polycrystalline composition.

After the polycrystalline composition has been formed, the housing 102 is opened at the outlet side. Opening on the outlet side helps localize any introduced contaminants to the chamber 108 caused by the opening to the chamber side proximate to the outlet 118. Localizing the contaminants proximate to outlet 118 reduces the distance the contaminants must travel to purge from the chamber 108, and confines the path of contaminants to a region in which contaminants are less likely to contact any grown crystal, or crystalline composition growing surface, e.g., inner surface of crucible 120. Further, not opening the housing on the inlet side decreases the chance of a leak close to the inlet in a subsequent run. The configuration reduces the chance of contaminants contaminating the produced crystals.

An apparatus 200 in accordance with an embodiment is shown in Fig. 2. The apparatus 200 includes a housing 202, and an energy source 204 proximate to the housing 202. The housing 202 includes an inner wall 206 and an outer wall 208. An inlet 209 extends through the outer wall 208, but stops short of the inner wall 206. The outer wall 208 has an outward facing surface. An inward facing surface or inner surface 212 of the inner wall 206 defines a chamber 214.

The inner wall 206 is nested within, and spaced from, the outer wall 208. In one embodiment, the space between the walls 206 and 208 is used to circulate an environmental control fluid which enters the space through the inlet 209 configured for that purpose. The outer wall 208 is formed from metal, while the inner wall 206 is made of high purity quartz or a ceramic material such as aluminum oxide. The energy source 204 is proximate to the outer wall 208.

A first inlet 216, a second inlet 218, a raw material inlet 224, a dopant inlet 232, and an outlet 226 may extend through the inner and outer walls 206 and 208. A plurality of valves 215, 220, 223, 233 is disposed, one/ tube, within the feed tubes that extend from sources to the corresponding inlets 216, 218, 224, 232. The individual feed tubes are not identified with reference numbers. And, the outlet 226 may have a valve 227 that may allow or block the flow of fluid there through.

The first inlet 216 may communicate with a nitrogen-containing gas source 217 and flow a nitrogen-containing gas into the chamber 214. The nitrogen-containing gas may include ammonia. The nitrogen-containing gas is diluted with the carrier gas. The carrier gas is argon, and is controllable separately from the nitrogen-containing gas flow. The second inlet 218 is in communication with a halide-containing gas source 219. The second inlet 218 allows a halide-containing gas to flow from the halide-containing gas source 219 into the chamber 214. The valve 220 controls the flow of the halide-containing gas from the halide-containing gas source 219 through the second inlet 218 and into the chamber 214. Examples of halide-containing gas include hydrogen chloride, which can be diluted with the carrier gas. The raw material inlet 224 communicates with a raw material reservoir 222. An exit end of the raw material inlet 224 is positioned so as to flow raw material leaving the inlet 224 into a crucible 230. The valve 223 may control the flow of the raw material from the reservoir 222 through the raw material inlet 224 and into the chamber 214.

The Group III metal raw material flowing through raw material inlet 224 is gallium. In one embodiment, the raw material is in a molten form. For handling Group III raw materials in a molten form, in one embodiment the inlet 224 comprises a material that does not corrode or degrade when comes into contact with the molten metal. In one embodiment, the raw material inlet 224 comprises a material selected from a high purity fused quartz or alumina. In another embodiment, the raw material inlet 224 is made of a composition comprising boron nitride, titanium diboride, and about 0.15 to 10 wt. % of rare earth metal compound selected from one of an oxide, a carbide, a nitride, and mixtures thereof.

The dopant source (not shown) communicates with the chamber 214 through the dopant inlet 232. The valve 233 is switched on/off to open or block a flow of dopant from the dopant source into the chamber 214. In the illustrated embodiment, the dopant includes silicon, which is in the form of SiCl₄.

The outlet 226 allows for excess material to exit the chamber 214. The valve 227 can open or dose, and by closing, a back pressure might be built up as additional materials are flowed into the chamber 214 and the temperature is increased.

A plurality of crucibles 230 is provided in the chamber 214. The crucibles 230 are arranged horizontally relative to each other. Sensors 236 and 237 are provided to monitor the pressure and temperature, or other process parameters within the chamber 214.

As disclosed hereinabove, the environmental control fluid flows in the space between the walls through the inlet 209. The inlet 209 communicated with a circulation system (not shown) to circulate the fluid in the space between the walls. The inlet 209 may include a valve 211 to adjust or optimize the circulation in the space between the walls. Flanges 210 meant for vacuum systems are used to form a leak proof connection. The fluid circulation system may have provision to heat or cool the fluid. The chamber 214, along with its contents, is cooled or heated through this arrangement.

A control system may include a controller 234 that may communicate with the various components as indicated by the communication lines. Through the lines, the controller 234 may receive information, such as signals, from sensors 236, 237. The controller 234 may signal to one or more of the valves 215, 220, 223, 227, 233, which may respond by opening or closing. The valve 211 may communicate with the controller 234, and through which the controller 234 may control the flow of the environmental control fluid from the circulation system. Thus, the controller 234 may monitor and may control the overall reaction conditions.

Prior to operation, the chamber 214 may be evacuated. The controller 234 may activate the valve 227 and a vacuum pump (not shown) to evacuate the chamber 214. The chamber 214 may be flushed with inert carrier gas. The energy source 204 may be activated to heat, and thereby volatilize, any volatile contaminants. The chamber 214 may be heated to a temperature 50-150°C higher than the operating temperature, and held for between about 5 minutes and 24 hours, in order to thoroughly outgas the interior components of chamber 214. The successive evacuation and purging may remove the contaminants from the chamber 214.

During operation, the controller may activate the valve 223 to start a flow of raw material from the reservoir 222 to the crucibles 230 through the raw material inlet 224. The dopant is flowed into the crucible through the dopant inlet 232 in response to the opening of the corresponding valve 233. The controller may adjust the rates of flow of materials by adjusting the degree to which the corresponding valves are open or closed. The controller 234 may communicate with the sensors 236, 237. The temperature and pressure within the chamber are raised to determined levels by the controller 234 activating the energy source 204, and/or adjusting the outlet valve 227.

Once the desired temperature and pressure have been attained, the nitrogen-containing gas is introduced in the chamber 214 through the first inlet 216. Alternatively, the nitrogen-containing gas is introduced in the chamber in the beginning of the heating cycle. The halide-containing gas is flowed in through the second inlet 218. The controller may adjust the flow rate of these gases by controlling the respective valves 215, 220.

The raw material including the dopants may react with the nitrogen-containing gas in the presence of the halide-containing gas. The reaction may proceed until the raw material reacts to form the metal nitride. In the illustrated embodiment, a silicon doped GaN is formed.

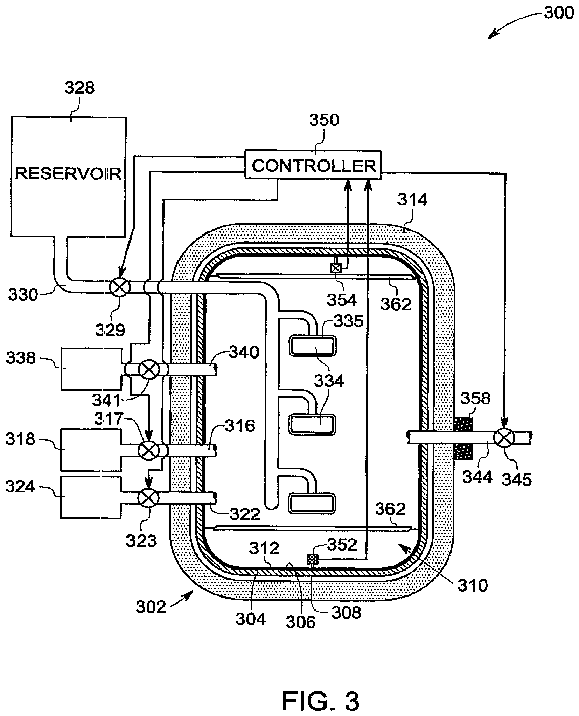

Fig. 3 is a schematic representation of an apparatus 300 in accordance with an embodiment. The apparatus 300 may include a housing 302, the housing 302 having a wall 304, the wall 304 having an inner surface 306 and an outer surface 308. The inner surface 306 of the wall 304 may define a chamber 310, within which reaction takes place to form the nitride. The apparatus 300 further may include an energy source 314, a raw material source 328, a dopant source 338, a carrier gas source (not shown), a nitrogen-containing gas source 318, and a halide-containing gas source 324. Tubing may connect the various sources 328, 338, 318, 324 to the chamber 310 via corresponding inlets 330, 340, 316, 322. Each inlet 330, 340, 316, 322 may have a corresponding valve 329, 341, 317, 323 disposed between the corresponding source 328, 338, 318, 324 and the housing 302. Coupled to the inner surface 306 is a pressure sensor 352 and a temperature sensor 354. An outlet 344, with a corresponding valve 345, extends through the wall 304. A control system includes a controller 350 that communicates with each valve 317, 323, 329, 341, 345 and each sensor 352, 354.

Crucible 334 is disposed within the chamber 310, and is stacked one over the other to obtain a vertical configuration. The crucible material is fused silica. A liner 335 is disposed along the crucible 334. The liner of graphite.

A graphite liner 312 may line the inner surface 306 of the inner wall 304. The liner 312 may reduce or prevent material deposition on the inner wall 304. A removable liner 312 may facilitate cleaning between uses. An outlet heater 358 adjoins the outlet 344. A set of baffles 362 is provided within the chamber. The baffles shown in the Fig. is a diagram representation including fins and/or blades, which promote mixing in a determined manner.

Prior to use, the chamber 310 is evacuated through the outlet 344. The evacuated chamber 310 is purged with inert carrier gas. Once evacuated and purged, the chamber 310 is sealed and the controller 350 activates the energy source 314, which adjoins the wall 304 along the outer surface 308, to supply thermal energy to the chamber 310. Pre-heating in this manner may remove volatile contaminants. The controller 350 may signal the valve 329 and allow raw material to flow from the raw material source 328 into the chamber 310 through the raw material inlet 330. The raw material inlet 330 is maintained at a temperature above the melting point of the metal to facilitate the flow of the raw material. The dopant may include magnesium, and is added to, or metered into, the flow of raw material. The raw material inlet 330 is configured such that the raw material flows into each crucible from open ends of the raw material inlet 330.

Because materials are now flowing into a sealed chamber 310, the outlet 344 may allow out flow of material, such as unreacted gas. The flow rate of gases from the chamber 310 is controlled by the controller 350 signaling the valve 345. The outlet heater 358 may maintain the outlet 344 at a pre-determined temperature. Heating the outlet 344 may decrease or prevent the formation in the outlet of solids such as ammonium halides, which may interfere with fluid flow through the outlet 344.

With the raw material and dopant disposed within a crucible, and the chamber maintained at the pre-determined temperature, the controller 350 may control the appropriate valves to allow for a flow of nitrogen-containing gas and of halide-containing gas to begin flowing into the chamber 310. The gases may contact the raw material and react to form the polycrystalline composition, doped with any dopant that might be present.

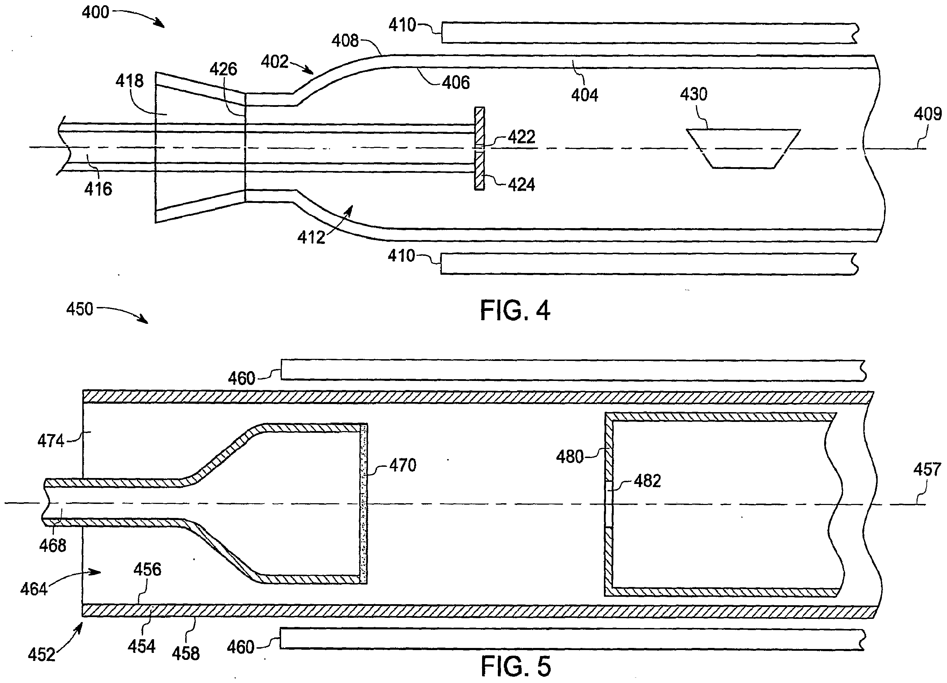

Fig. 4 is a schematic view of an apparatus 400 detailing the inlets in accordance with an embodiment. The apparatus 400 may include a housing 402 having a wall 404, the wall 404 may have an inner surface 406 and an outward facing surface 408, as illustrated in the Figure. The wall 404 is radially spaced from an axis 409. An energy source 410 is provided proximate to the outer surface 408. The inner surface 406 of the wall 404 may define a chamber 412.

The apparatus 400 may further include inlets 416 and 418. The inlet 416, in one embodiment, is a single walled tube, and extends into the chamber 412 through the wall 404. The inlet 416 is nested within, and spaced from the inner surface 406 of the wall 404. An exit end of the inlet 416 may define an aperture 422. A baffle 424 may adjoin the aperture 422. The spacing between the inlet 416 and the inner surface 406 of the wall 404 may define the inlet 418. Further, an aperture or opening 426 is provided in the inlet 418. A crucible 430 is disposed within the chamber 412.

A halide-containing; gas is introduced into the chamber 412 from a source (not shown) through the inlet 416, and a nitrogen-containing gas is introduced into the chamber 412 from a source (not shown) through the inlet 418. The inlets 416 and 418 is configured such that the baffle 424 provided in the inlet 416 may assist in proper mixing of the gases flowing in to the chamber 412 through the inlets.

The apparatus 400 may further include components not shown in the Figure such as, a control system including a controller which may control the overall reaction, valves for adjusting and/or controlling the flow of materials to and/or from the chamber, inlets for introducing raw materials and/or dopants into the chamber, sources from where raw materials and/or dopants are flowed into the chamber, sensors for monitoring the temperature, pressure and composition within the chamber, and the like. The working of the apparatus is explained with reference to above described embodiments.

Fig. 5 is a schematic side view of an apparatus 450 detailing the inlets, in accordance with yet another embodiment. The apparatus 450 may include a housing 452, having a wall 454 with an inner surface 456 and an outer surface 458. The wall 454 is radially spaced from an axis 457. An energy source 460 is provided proximate to the outer surface 458. The inner surface 456 of the wall 454 may define a chamber 464.

The apparatus further includes an inlet 468. The inlet 468 is nested within, and spaced from the inner surface 456 of the wall 454. The inlet 468 extends into the chamber 464 and the exit end of the inlet 468 includes a frit 470. An inlet 474 is formed in the space between the inlet 468 and the inner surface 456 of the wall 454. At a pre-determined distance from the inlets 468, 474, a baffle 480 is provided within the chamber 464. The baffle 480 may further include an aperture 482.

The inlet 468 is in communication with a halide-containing gas source (not shown) and may flow in the halide-containing gas to the chamber 464 through the frit 470. The frit may filter the halide-containing gas thus reducing contamination. The frit may also diffuse the gas over a wider surface area. A nitrogen-containing gas is introduced into the chamber 464 through the inlet 474. The baffle 480 with an aperture 482 may promote pre-mixing of the gases. The apparatus 450 may include at least one crucible containing raw materials. The apparatus 450 may further include components not shown in the Figure such as, a control system, sensors which may communicate with the chamber and the control system, valves to control the flow of gases and the raw materials into the chamber, and the like. The working of the apparatus is explained with reference to above described embodiments.

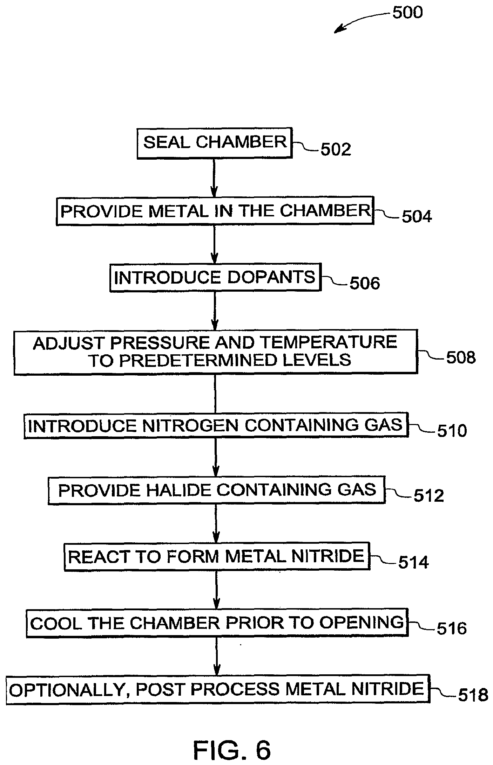

Fig. 6 is a flow chart depicting a method 500 for preparing a metal nitride in accordance with the present disclosure. The method starts by evacuating, purging, and otherwise decontaminating a chamber to remove trace impurities, and then sealing the chamber to avoid recontamination (step 502). The environment in the chamber is adjusted to determined levels. The temperature of the chamber is maintained between 800 - 1300°C, and the pressure within the chamber is greater than ambient.

Raw material, in the form of very pure metal, is introduced in the chamber (step 504). To introduce the molten metal, a flow tube is used to flow in the metal from a metal containing reservoir to the chamber. If necessary, pressure is used to force the metal through the fill tube, for example, through overpressure of the metal-containing reservoir or a pump. The temperature of the reservoir and the fill tube is maintained above the melting point of the metal to facilitate metal flow.

Dopant is introduced in the chamber (step 506) as a dopant precursor. The dopant precursor is flowed into the chamber from a dopant source.

The temperature within the chamber is raised to between 800 - 1300°C, and the pressure is raised at least one dimension greater than 1 meter, for a period greater than 30 minutes (step 508). In step 510, a nitrogen-containing gas is introduced in the chamber. The gas is flowed from a nitrogen-containing gas source through an inlet into the chamber. The flow rate of the nitrogen-containing gas is greater than 250 (standard) cm³/min.

A halide-containing gas is introduced into the chamber (step 512). Optionally, steps 510 and 512 are interchanged. The flow rate of the halide-containing gas may be greater than 25 cm³/min. The ratio of the flow rate of the nitrogen-containing gas to the flow rate of the halide-containing gas is about 10:1.

The metal may react with the nitrogen-containing gas in the presence of the halide to form a metal nitride (step 514). The halide affects the reaction between the metal and the nitrogen-containing gas in a determined manner.

The reaction may proceed through a vapor transport and/or a wicking effect. The metal nitride crust may form on top of the molten metal within the crucible. The crust is slightly porous. The metal is vapor transported or, if liquid, wicked to the top of the crust through the pores and reacts with the nitrogen-containing gas. The reaction may deposit additional metal nitride and add to the crust. The reaction proceeds until virtually all the metal has undergone reaction. Additional metal may be flowed into the chamber from the reservoir.

The chamber is cooled in step 516. The excess nitrogen-containing gas and hydrogen halide flows out from the reaction zone and ammonium halide may condense on cooler regions of the chamber. In one embodiment, the outlet is kept hot so as to facilitate downstream trapping of ammonium halide; or alternatively a cold wall section is incorporated to facilitate condensation of the ammonium halide. The chamber may be opened on the outlet side to minimize leakage through the inlet side. The metal nitride is removed through the outlet side.

Optionally, the metal nitride formed is further processed (step 518). In one embodiment, at least one surface of the metal nitride is subjected to one or more of scraping, scouring or scarifying. The surface may be further subjected to oxidation in air or in dry oxygen and it may further be boiled in perchloric acid. For use as a sputter target, the metal nitride is trimmed, and the front and back surfaces are ground, lapped, and/or polished. The residual contamination resulting from the post-processing step may be removed by washing, sonicating, or both. Washing and sonicating may be performed in, for example, organic solvents, acids, bases, oxidizers (such as hydrogen/oxide), and the like. The metal nitride may be annealed in an inert, nitriding, or reducing atmosphere. The annealing may also be performed in pure ammonia at a temperature of about 800 degree Celsius to 1200 degree Celsius for a period of time in a range of from 30 minutes to 200 hours.

Other processing may be done for use as a source material for crystalline composition growth. For use as a source material, the metal nitride is pulverized into particulates. The particles may have an average diameter in a range of from 0.3 mm to 10 mm. The pulverizing may be carried out through, for example, compressive fracture, jaw crushing, wire sawing, ball milling, jet milling, laser cutting, or cryo-fracturing. Post pulverization cleaning operations may remove adventitious metal introduced by the pulverization operation, un-reacted metal, and undesirable metal oxide.

Rather than pulverizing, in one embodiment, a thin platinum (Pt) film is sputtered onto the surface of metal nitride polycrystalline material. The sputtered surface may be etched using a solution of methanol; hydrogen fluoride; and hydrogen peroxide. The catalytic reduction of peroxide on the Pt surface may inject electron-hole pairs on the metal nitride. These electron / hole pairs are subject to in-plane drift and may assist the chemical etching. The result is pores formed in the metal nitride, and the pores placement and dimensions are controlled by the sputtering and etching process.

The examples provided are merely representative of the work that contributes to the teaching of the present application. Accordingly, these examples are not intended to limit the invention, as defined in the appended claims.

EXAMPLE 1 - Preparation of polycrystalline GaN. About 100 g. of gallium metal is placed in each of three polyethylene bottles. The polyethylene bottles are immersed in water that is hot enough to melt the gallium metal. Gallium has a melting point of about 29.8 degree Celsius.

The molten metal is transferred to a cylindrical quartz crucible. The crucible has a graphite liner of about 12.5 µm thickness. The crucible has an outer diameter of ∼ 4 cm and a length of ∼ 20 cm. About 297.2 g net of gallium is transferred to the crucible. The liquid metal forms a layer with a maximum thickness of about 1 cm in the crucible. Argon gas is passed over the liquid gallium metal to cool and to blanket the metal. The liquid gallium solidifies in the crucible as it cools.

The crucible is placed inside a horizontal quartz reactor tube with a 250 µm thick graphite foil liner. The horizontal quartz tube nests inside a horizontal quartz reactor tube. The inner quartz tube with the graphite foil liner serves to protect the quartz reactor, which is susceptible to cracking during cooling. The cracking is attributable to GaN deposits on the inner wall during a run, and the thermal expansion mismatch between the quartz and the GaN.

The reactor is evacuated and flushed several times with high purity argon gas. The flow rate of the argon gas is maintained at 50 cm³/min. High purity anhydrous ammonia is introduced through tubing inlets into the reactor at a rate of 100 cm³/min. The temperature inside the reactor is increased using a Lindberg split furnace. The flow of argon/ammonia gas mixture continues for about 2 hrs. During that time, the temperature is ramped steadily until the soak temperature of about 980°C is reached. Once the soak temperature is reached, the argon flow is stopped and, the flow rate of ammonia is increased to 200 cm³/min. High purity hydrogen chloride (HCI) gas is introduced into the reactor at a flow rate of 25 cm³/min.

The ammonia and HCI gases are purified using in-situ purifiers directly before being added. Aeronex Model SS-500KF-Y-4R is used for purifying ammonia, and Aeronex Model 45-03493 is, used for purifying HC1. Aeronex is commercially available from Mykrolis Corporation (San Diego, California). The purification reduces the levels of moisture, oxygen and other impurities. After temperature soaking the reactor for 24 hours at 980 degree Celsius, the HCI gas flow is turned off. The reactor is kept at the soak temperature of 980 degree Celsius for 20 minutes. The furnace is cooled to 300 degree Celsius with a gradual temperature ramp down over a period of about 2 hours. Argon gas is then reintroduced at a flow rate of 50 cm³/min., and the ammonia gas flow is turned off. The reactor is cooled to room temperature under an argon blanket.

The gallium in the crucible converts to a crust of polycrystalline GaN filling the upper portion of the crucible. No metallic gallium is visible. The net weight changes to 345.7 g, which represents a weight increase of 16.3 %. The theoretical weight increase is 20.1 % if the gallium is fully converted to the stoichiometric GaN, and there is no loss due to recovery or vaporization as gallium halide.

Part of the polycrystalline GaN crust is prepared for chemical analysis and other characterization. Analysis of the polycrystalline GaN is carried out by interstitial gas analysis (IGA) and shows an oxygen content of 16 ppm (w/w). The GaN shows a hydrogen content of less than 3 ppm, which is within the detection limit of the instrument. The polycrystalline GaN is also analyzed by glow discharge mass spectrometry (GDMS), and Table 1 summarizes the results for three samples.

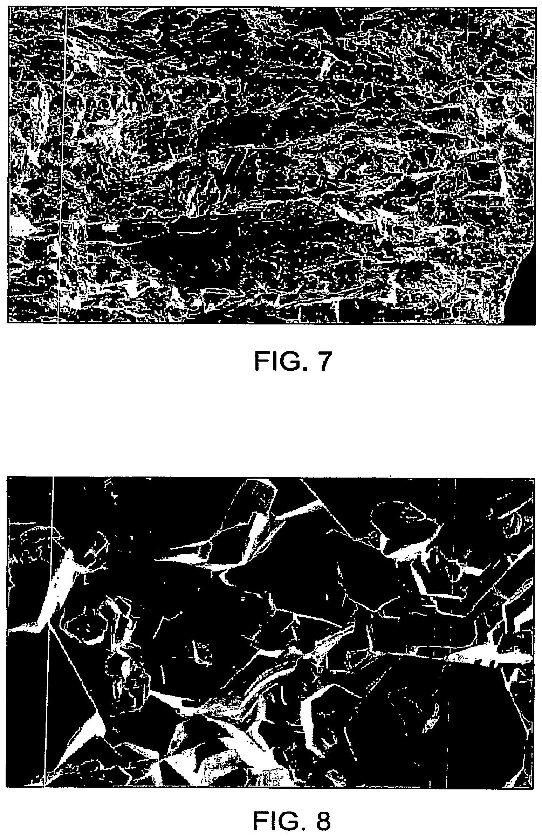

The SEM image given in Fig. 7 show the cross-section of the polycrystalline GaN. The growth surface of the polycrystalline GaN at 300 times magnification is shown in Fig. 8. The polycrystalline GaN is found to have a columnar structure with the c-axis closely aligned with the growth direction.

Two rectangular prisms are cut from the polycrystalline GaN and the faces and edges ground flat. The apparent densities are determined by measuring the weights and dimensions of the prisms. The two pieces have apparent densities of 5.72 and 5.69 g/ cubic centimeter., corresponding to 93.8 and 93.3 % of the theoretical value, respectively.

EXAMPLE 2 - Preparation of polycrystalline GaN Example 2 is similar to Example 1, except that a larger load is used in a longer crucible. About 500 g. of gallium are used in this example rather than 300 g of gallium in Example 1. Also, the soaking temperature is increased from 980 degree Celsius in the Example 1 to 1000 degree Celsius in Example 2.

Gallium metal is placed in 5 polyethylene bottles, each bottle containing 100 g. of gallium. The gallium metal is melted and transferred to a quartz crucible for a net of 497.3 g. of gallium. Following the steps described in Example 1, the crucible with solidified gallium is placed in the reactor.

The gallium in the crucible converts to a crust of polycrystalline GaN. The crust does not have any visible metallic gallium. The net weight is 565.9 g. , which represents a weight increase of 13.8 %. Some of the polycrystalline GaN crust is pulverized for chemical analysis and other characterization. The polycrystalline GaN is analyzed for oxygen and hydrogen by IGA and shows an oxygen content of 64 ppm oxygen and a hydrogen content of less than 3 ppm. GDMS analysis for the presence of other elements produced results that are included in Table 1.

EXAMPLE 3 - Preparation of polycrystalline GaN This example is similar to Examples 1 and 2, except a smaller load is used. About 200 g. of gallium versus the 300 g. of gallium of Example 1. Other changes include a shorter temperature soak time (20 hours versus 24 hours), and higher NH3 and HCI flow rates. The flow rates are 600 cm³/min. of NH₃ and 30 cm³/min. of HC1 versus the 200 cm³/min. of ammonia and the 25 cm³lmin. of HC1.

The gallium in the crucible converts to a crust of polycrystalline GaN. There is no visible metallic gallium. The net weight is 231.3 g, which represents a weight increase of 16.7 %. Some of the polycrystalline GaN crust is broken for chemical analysis and other characterization. Analysis of the polycrystalline GaN by IGA shows 71 ppm oxygen and less than 3 ppm hydrogen. GDMS analyses of other elements are included in Table 1.

**Table 1: IGA/GDMS Analysis of Polycrystalline GaN**

| | Concentration (weight ppm) | | |
|---|---|---|---|
| Element | Example 1 | Example 2 | Example 3 |
| H | <3 | <3 | <3 |
| Li | < 0.005 | < 0.005 | < 0.005 |
| B | 0.02 | 0.12 | 0.008 |
| C | <5 | < 2 | 3.3 |
| O | 16 | 64 | 71 |
| F | < 0.01 | < 0.01 | < 0.01 |
| Na | < 0.005 | 0.02 | 0.008 |
| Mg | 0.17 | 0.04 | 0.17 |
| Al | 0.21 | 0.21 | 0.07 |
| Si | 0.83 | 0.27 | 0.31 |
| P | 0.02 | 0.04 | 0.83 |
| S | 0.62 | 0.62 | <0.05 |
| Cl | 2.4 | 1.3 | 0.12 |
| K | < 0.05 | < 0.05 | < 0.05 |
| Ca | 0.75 | < 0.05 | < 0.05 |
| Ti | < 0.005 | < 0.005 | < 0.005 |
| Cr | 0.02 | < 0.005 | 0.02 |
| Mn | < 0.01 | < 0.01 | < 0.01 |
| Fe | 3.3 | 0.21 | 0.37 |
| Co | < 0.005 | < 0.005 | < 0.005 |
| Ni | 0.008 | < 0.005 | < 0.005 |
| Cu | < 0.005 | < 0.005 | < 0.005 |
| Zn | < 0.05 | < 0.05 | < 0.05 |
| Mo | <0.05 | <0.05 | <0.05 |
| Ag | < 0.5 | < 0.5 | < 0.5 |
| W | <0.01 | <0.01 | <0.01 |
| Au | < 0.1 | < 0.1 | < 0.1 |

EXAMPLE 4 - Preparation of polycrystalline GaN While Examples 1 - 3 illustrate polycrystalline GaN synthesis/formed in a small laboratory reactor with a single crucible, Example 4 illustrates a run made with a scaled-up reactor. The reactor has an outer diameter of 15 cm, and into which four smaller quartz inner tubes each having a 59 mm outer diameter is placed. A graphite foil liner such as the one in Example 1 is placed in the reactor. Two crucibles each are placed in the four inner quartz tubes along a 3-Zone THERMCRAFT split furnace.

Example 4 follows the procedure of Example 3 unless stated otherwise. The reactor is evacuated and purged with 99.999% purity argon gas several times. The argon gas flow rate is maintained at 1400 cm³/min. and 99.99995% purity ammonia is introduced at 1200 cm³/min. The reactor is heated in the argon/ammonia mixed flow to a soak temperature of 1000 degree Celsius in about 4 hours. When the soak temperature is reached, the argon flow rate is reduced to 200 cm³/min., the ammonia flow rate is increased to 2400 cm³/min., and 99.999% purity hydrogen chloride (HCI) gas is introduced at a flow rate of 200 cm³/min. The ammonia and HCI gases are used with in-situ purifiers (Aeronex Model CES500KFSK4R for ammonia, and Aeronex Model CE500KFC4R for HCI). After a soak period of 24 hours at 1000 degree Celsius, the HCI flow is turned off, and the furnace is cooled to 650 degree Celsius over 5 hours. An argon flow is introduced through the ammonia line at a flow rate of 600 cm³/min., the ammonia flow is then turned off, and the reactor is cooled to room temperature in an argon blanket.

The gallium in each of the four crucibles converts to crusts of polycrystalline GaN. No metallic gallium is visible. Some of the polycrystalline GaN is taken for chemical analysis and other characterizations. Oxygen analysis is carried out on duplicate samples using IGA and duplicate samples using LECO. The results show 71 ppm and 63 ppm oxygen by IGA, and 30 ppm and 63 ppm oxygen by LECO.

Strength test specimens are prepared from the polycrystalline GaN. The polycrystalline GaN crusts are cut, ground, lapped and polished into discs of about 1.25 cm in diameter and 0.75 cm thick. The specimens are weighed to obtain the apparent density. The results are summarized in Table 2. The apparent densities lie in the range of 5.36 to 5.51 g/ cubic centimeter, corresponding to 87.8 to 90.4 % of the theoretical density and an apparent porosity between 9.6 and 12.2 %.

**Table 2. Polycrystalline GaN apparent density results:**

| Sample | Apparent density (g cm⁻³) | % Theoretical density |
|---|---|---|
| 001-2 | 5.51 | 90.4 |
| 001-3 | 5.37 | 88.0 |
| 002-2 | 5.36 | 87.8 |
| 002-4 | 5.50 | 90.2 |

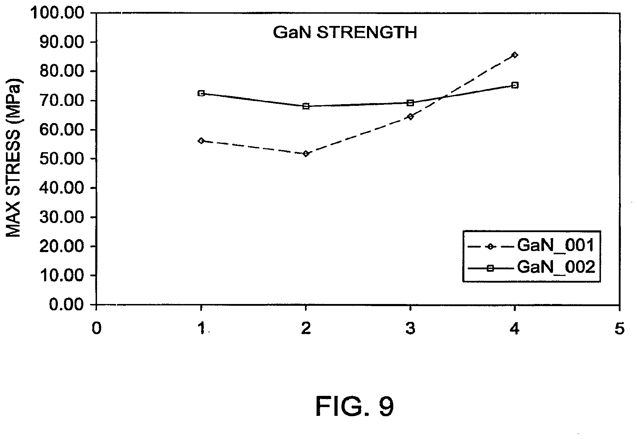

The specimens are tested using the ring-on-ring Monotonic Equibiaxial Test Method described in ASTM C1499. The testing machine used is an INSTRON Series IX screw type with a loading rate of 30 to 35 MPa/ sec. The diameter of the supporting ring and loading ring are 11.91 mm and 6 mm, respectively. Both rings have a contact radius of 0.25 mm. To reduce friction, 0.127 mm thick graphite foil discs are placed between the specimens and the rings. Maximum load for each specimen is taken from loading data, which is recorded every 0.05 milliseconds during the test. Maximum strength for each specimen is calculated in accordance with the standard. The test results on a total of 8 specimens (four each from two polycrystalline GaN synthesis runs) are as given in Table 3, below. A graph of the bend strength of GaN is given in Fig. 9.

**Table 3. Polycrystalline GaN strength test results:**

| | Strength (MPa) |
|---|---|
| Mean | 67.96 |
| Standard Dev | 10.73 |
| Minimum | 51.78 |
| Maximum | 85.75 |

## Claims

1. A composition, comprising:
a polycrystalline gallium nitride (GaN) having a plurality of grains, and the grains having a columnar structure; and, one or more of
the grains having an average grain size in a range of from 10 nm to 1 mm;
the gallium nitride having an impurity content of less than 200 ppm; the gallium nitride having a porosity in volume fraction in a range of from 0.1 % to 30 %;
the gallium nitride having an apparent density in a range of from 70 % to 99.8 % of the theoretical density value corresponding to the gallium nitride;.

2. The composition of claim 1, wherein one of the following (i)-(vii):
(i) the average number of grains in the plurality is in a range of from 100 - 100,000 per cm³ and wherein the porosity of the gallium nitride in volume fraction is in a range of from 0.1 % to 10 %;
**(ii)** an average grain diameter is in a range of from 1 mm to 10 micrometers;
(iii) the impurity content of the gallium nitride is in a range of from 15 - 100 ppm, and the impurity consists essentially of oxygen;
**(iv)** the oxygen content of the gallium nitride is less than 20 ppm;
**(v)** further comprising one or more dopants capable of producing one or more of n-type material, p-type material, semi-insulating material, magnetic material and luminescent material;
**(vi)** the dopant concentration is greater than 10¹⁶ atoms per cm³;
**(vii)** the polycrystalline gallium nitride has an inter-grain bend strength greater than 20 Mpa.

3. An article comprising the composition of claim 1 or 2, wherein the article has a shape with one or more dimensions of length, height or width in a range greater than 1 mm.

4. The article of claim 3, wherein the article has one or more surfaces that have a root mean square roughness that is less than 1 nm.

5. The article of claim 3 or 4, wherein the article has one or more surface that has been etched, polished, cut, or diced, defining a wafer.

6. An electronic device, comprising the article of any of claims 3-5 and one or more structure secured to the article, wherein:
the secured structure being selected from the group consisting of a cathode, an anode, an electrically conducting lead, or a combination of two or more thereof, and
the device being operable as one or more of a transducer, a diode, a detector, or a sensor.

## Patentansprüche

1. Zusammensetzung, umfassend:
ein polykristallines Galliumnitrid (GaN) aufweisend eine Vielzahl an Körnern und Körnern aufweisend eine Säulenstruktur; und einer oder mehrere von den Körnern aufweisend eine durchschnittliche Korngröße in einem Bereich von 10 nm bis 1 mm;
wobei das Galliumnitrid einen Verunreinigungsgehalt von weniger als 200 ppm aufweist; wobei das Galliumnitrid eine Porosität im Volumenanteil in einem Bereich von 0,1% bis 30% aufweist;
wobei das Galliumnitrid eine scheinbare Dichte in einem Bereich von 70% bis 99,8% des theoretischen Dichtewerts aufweist, der dem Galliumnitrid entspricht.

2. Zusammensetzung nach Anspruch 1, wobei einer der folgenden (i) - (vii):
(i) die durchschnittliche Anzahl von Körnern in der Vielzahl liegt in einem Bereich von 100-100.000 pro cm³ und wobei die Porosität des Galliumnitrids im Volumenanteil in einem Bereich von 0,1% bis 10% liegt;
(ii) ein durchschnittlicher Korndurchmesser liegt in einem Bereich von 1 mm bis 10 Mikrometer;
(iii) der Verunreinigungsgehalt des Galliumnitrids liegt in einem Bereich von 15-100 ppm, und die Verunreinigung besteht im Wesentlichen aus Sauerstoff;
(iv) der Sauerstoffgehalt des Galliumnitrids beträgt weniger als 20 ppm;
(v) zudem umfassend einen oder mehrere Dotierstoffe, die in der Lage sind, eines oder mehrere aus n-Typ-Material, p-Typ-Material, halbisolierendem Material, magnetischem Material und Lumineszenzmaterial herzustellen;
(vi) die Dotierstoffkonzentration ist größer als 10¹⁶ Atome pro cm³;
(vii) das polykristalline Galliumnitrid weist eine Biegefestigkeit zwischen den Körnern höher als 20 MPa auf.

3. Artikel, umfassend die Zusammensetzung nach Anspruch 1 oder 2, wobei der Artikel eine Form mit einer oder mehreren Abmessungen von Länge, Höhe oder Breite in einem Bereich höher als 1 mm aufweist.

4. Artikel nach Anspruch 3, wobei der Artikel eine oder mehrere Oberflächen aufweist, die eine mittlere quadratische Rauheit aufweisen, die kleiner als 1 nm ist.

5. Artikel nach Anspruch 3 oder 4, wobei der Artikel eine oder mehrere Oberflächen aufweist, die geätzt, poliert, geschnitten oder gewürfelt wurden, wodurch ein Wafer definiert wird.

6. Elektronische Vorrichtung, umfassend den Artikel nach einem der Ansprüche 3-5 und eine oder mehrere an dem Artikel befestigte Strukturen, wobei:
die befestigte Struktur aus der Gruppe bestehend aus einer Kathode, einer Anode, einer elektrisch leitenden Leitung oder einer Kombination von zwei oder mehr davon ausgewählt ist und
wobei die Vorrichtung als einen oder mehrere von einem Wandler, einer Diode, einem Detektor oder einem Sensor betrieben werden kann.

## Revendications

1. Composition, comprenant :
un nitrure de gallium polycristallin (GaN) comportant une pluralité de grains, et les grains ayant une structure en colonnes ; et, un ou plusieurs des éléments suivants
des grains ayant une grosseur de grain moyenne comprise entre 10 nm et 1 mm ;
le nitrure de gallium ayant une teneur en impuretés inférieure à 200 ppm ; le nitrure de gallium ayant une porosité en pourcentage volumique comprise entre 0,1 et 30 % ;
le nitrure de gallium ayant une densité apparente comprise entre 70 et 99,8 % de la valeur de la densité théorique correspondant au nitrure de gallium.

2. Composition selon la revendication 1, dans laquelle elle comporte un des éléments suivants (i) - (vii) :
(i) le nombre moyen de grains dans la pluralité est compris entre 100 et 100000 par cm³ et dans laquelle la porosité du nitrure de gallium en pourcentage volumique est comprise entre 0,1 et 10 % ;
(ii) le diamètre moyen des grains est compris entre 1 mm et 10 micromètres ;
(iii) la teneur en impuretés du nitrure de gallium est comprise entre 15 et 100 ppm, et les impuretés consistent essentiellement en de l'oxygène ;
(iv) la teneur en oxygène du nitrure de gallium est inférieure à 20 ppm ;
(v) elle comprend de plus un ou plusieurs dopants en mesure de produire un ou plusieurs des matériaux suivants : matériau de type n, matériau de type p, matériau semi-isolant, matériau magnétique et matériau luminescent ;
(vi) la concentration de dopant est supérieure à 10¹⁶ atomes par cm³ ;
(vii) le nitrure de gallium polycristallin possède une résistance à la flexion inter-grains supérieure à 20 MPa.

3. Article comprenant la composition selon la revendication 1 ou 2, dans lequel l'article a une forme ayant une ou plusieurs dimensions de longueur, de hauteur ou de largeur supérieure à 1 mm.

4. Article selon la revendication 3, dans lequel l'article comporte une ou plusieurs surfaces ayant une rugosité quadratique moyenne inférieure à 1 nm.

5. Article selon la revendication 3 ou 4, dans lequel l'article comporte une ou plusieurs surfaces ayant été gravées, polies, coupées ou coupées en dés, définissant une tranche.

6. Dispositif électronique, comprenant l'article selon l'une des revendications 3-5 et une ou plusieurs structures fixées à l'article, dans lequel :
la structure fixée étant choisie dans le groupe constitué par une cathode, une anode, un fil électriquement conducteur ou une combinaison de deux ou plusieurs de ces éléments, et
le dispositif pouvant fonctionner comme un ou plusieurs des éléments suivants : un transducteur, une diode, un détecteur ou un capteur.
